# FASCICULE DE BREVET EUROPEEN

(11) **EP 0 793 270 B1**
(45) Date de publication et mention de la délivrance du brevet: **30.08.2000**
(21) Numéro de dépôt: 97400429.3
(22) Date de dépôt: 26.02.1997
(51) Int. Cl.: H01L 23/42

(54) **Boîtier de composant(s) thermo-émissif(s) à transmission thermique améliorée, et son procédé de réalisation**
Gehäuse für thermische Strahlungsbauelemente mit verbesserter Wärmeleitung und Herstellungsverfahren dafür
Housing for thermal emission components with improved heat transfer caracteristics, and its method of fabrication

(30) Priorité: 01.03.1996 FR 9602619
(43) Date de publication de la demande: 03.09.1997
(73) Titulaire: MCB Industrie, 95100 Argenteuil (FR)
(72) Inventeur: Dupont, José Lionel Jacques, 49240 Avrille (FR)
(74) Mandataire: Bérogin, Francis

(56) Documents cités:
- DE-A- 2 749 848
- DE-U- 9 203 252
- US-A- 4 323 914
- US-A- 5 000 256

## Description

L'invention concerne, d'une manière générale, les techniques d'amélioration de la transmission de chaleur entre des boîtiers de composants assimilables à des éléments émetteur de chaleur et des refroidisseurs extérieurs, dénommés également dissipateurs thermiques ou drains thermiques, et chargés de contrôler la température desdits boîtiers de composants, destinés à être montés sous pression sur de tels drains ou dissipateurs thermiques, formant des radiateurs extérieurs, situés dans le milieu extérieur.

Plus précisément, l'invention est relative à un procédé d'amélioration de la transmission thermique entre au moins un boîtier de composant(s) thermo-émissif(s) et au moins un refroidisseur extérieur, et l'invention trouve plus particulièrement application au contrôle du refroidissement de composants thermo-émissifs en boîtiers, tels que des composants résistifs de puissance, du type utilisé dans les systèmes refroidis de l'électronique de puissance.

L'invention se rapporte également à des boîtiers de composants thermo-émissifs à transmission thermique améliorée, obtenus par la mise en oeuvre du procédé de l'invention, c'est-à-dire des boîtiers de composants assimilables à des sources thermiques et dont la réalisation intègre les techniques d'amélioration de la transmission thermique qui sont exposées dans le présent mémoire descriptif.

Les boîtiers de composants thermo-émissifs tels que les composants résistifs de puissance, qui, en fonctionnement normal, dégagent des quantités notablement importantes de chaleur, nécessitent d'être associés, en interface avec l'application des utilisateurs, à des drains thermiques extérieurs, destinés à évacuer dans le milieu extérieur les calories produites, et à maintenir les composants thermo-émissifs dans leur plage de température d'emploi admissible.

Indépendamment de la technologie et de la structure d'un drain thermique, ses performances en tant que refroidisseur sont grandement influencées par l'environnement de la jonction thermo-mécanique entre ce drain et un boîtier de composant(s) thermo-émissif(s) implanté sur ce drain extérieur au boîtier.

Il est connu que des paramètres qui influent sur la qualité d'une jonction thermo-mécanique entre deux surfaces en regard appliquées l'une contre l'autre sont notamment les suivants :
- la géométrie des surfaces en regard, en particulier leur planéité, rugosité et leur traitement de surface qui ont une importance primordiale,
- la pression d'application des surfaces l'une contre l'autre, des pressions de plusieurs dizaines de MPa étant souvent nécessaires pour obtenir des déformations microgéométriques et même macrogéométriques assurant une mise en contact suffisamment intime des surfaces de transfert thermique en regard, et
- la présence de fluides entre les surfaces, notamment de l'air, naturellement présent, dont la conductivité thermique est médiocre, et qui ne peut jamais être totalement éliminé, car l'inter-adaptation des surfaces en contact n'est pas parfaite même aux pressions de contact élevées.

Pour ces raisons, diverses techniques ont déjà été proposées et appliquées pour éviter les usinages coûteux ou traitements de surface sophistiqués des surfaces destinées à venir en contact, et/ou tenter de s'affranchir de pressions élevées, difficiles à mettre en oeuvre, pour le contact mutuel des surfaces de transfert thermique.

Parmi les différentes techniques proposées à cet effet, on connaît l'usage de produits dits "intercalaires", ayant pour fonction de combler les interstices d'une jonction entre deux surfaces de transfert thermique, dont les pressions de contact et usinages de surface sont moins poussés. Lorsque leur mise en oeuvre est correcte, les produits intercalaires ont de plus l'avantage de remplir les espaces occupés par de l'air dans les montages classiques de surfaces d'échanges thermiques appliquées l'une contre l'autre.

Il est connu que ces produits intercalaires, de natures diverses, doivent présenter, pour être efficaces, des caractéristiques bien précises, telles que :
- une malléabilité leur permettant d'épouser les irrégularités des surfaces en regard,
- une viscosité permettant une mise en oeuvre aisée, à l'épaisseur requise, et une adhérence suffisante sur les supports que constituent les surfaces en regard,
- une mouillabilité suffisante pour imprégner la microstructure superficielle des surfaces en regard,
- une très bonne conductibilité thermique,
- une absence d'effets néfastes sur le comportement en décharges électriques partielles entre les surfaces de transfert thermique,
- une neutralité physico-chimique par rapport aux matériaux voisins, et en particulier les matériaux constitutifs desdites surfaces d'échanges thermiques, et
- une stabilité dans le temps.

Afin de satisfaire à l'ensemble de ces contraintes, les utilisateurs se sont orientés vers des produits intercalaires du type graisses spéciales, matériaux composites divers, feuilles de métaux tendres suffisamment épaisses pour compenser les irrégularités de surface du boîtier de composant(s) thermo-émissif(s) et du radiateur extérieur, par fluage sous pression,
etc ...

Bien que ces produits intercalaires apportent des solutions satisfaisantes dans certains cas d'application, ils présentent toujours des inconvénients :
- une mise en oeuvre délicate, donc coûteuse et pesant sur la productivité des installateurs de tels boîtiers de composants thermo-émissifs,
- la nécessité d'utiliser des matériaux accessoires coûteux,
- le caractère alléatoire de la reproductibilité des épaisseurs déposées des produits intercalaires,
- le temps moyen entre défaillances (M.T.B.F.) est influencé par l'addition des produits intercalaires et ne peut être satisfaisant que si des procédures rigoureuses de montage et des conditions initiales de montage très précisément définies sont respectées,
- certains produits intercalaires, notamment les métaux tendres, à bas point de transition, nécessitent des phases de montée en température pour assurer les changements d'état permettant d'atteindre les performances recherchées,
- une propreté, après mise en place des produits intercalaires, qui est variable et dépendante de l'environnement, en particulier lorsque ces produits sont des graisses, et
- des difficultés rencontrées lors d'opérations de maintenance, à raison notamment des deux derniers inconvénients mentionnés ci-dessus.

Les inconvénients précités ne sont que partiellement évités par l'emploi, déjà proposé, d'opercules pelables protégeant des produits intercalaires tels que des graisses appliquées sur l'une des deux surfaces d'échanges thermiques destinées à coopérer, et tels que les opercules sont retirés au montage. En effet, des problèmes importants de maintenance subsistent au démontage, puisqu'une partie de la graisse déposée est emportée avec le boîtier du ou des composants thermo-émissifs, alors qu'une autre partie de la graisse reste sur la surface du drain thermique extérieur, ce qui impose des opérations de nettoyage et de redéposition de la graisse.

Le problème à la base de l'invention est de remédier aux inconvénients précités, et le but de l'invention est de proposer un boîtier de composant(s) thermo-émissif(s) perfectionné, ainsi qu'un procédé de réalisation d'un tel boîtier à l'aide de moyens simples favorisant les échanges thermiques entre le boîtier et un drain thermique extérieur, et garantissant au boîtier de composant(s) émetteur(s) de chaleur une jonction thermique avec un drain extérieur qui est d'une excellente qualité, reproductibilité et stabilité.

Les produits intercalaires connus de DE-U-9 203 252 et DE-A-2 749 848 comprennent une capsule consistant en une barrière physique déformable close contenant un fluide bon conducteur de la chaleur et qui est intercalée entre le boîtier et le refroidisseur. En outre DE-A-2 749 848 décrit une technique alternative selon laquelle la capsule est délimitée par la surface externe du refroidisseur et la barrière physique déformable, la barrière physique étant reliée à cette surface. Ce document mentionne une autre alternative selon laquelle la barrière physique est reliée au substrat sur lequel le boîtier est fixé de sorte que le boîtier est complètement immergé dans le fluide.

Le boîtier de composant(s) thermo-émissif(s) perfectionné et le procédé d'amélioration de la transmission thermique d'un boîtier selon l'invention trouveront une application particulièrement avantageuse sur tous les composants électriques, électroniques, actifs ou passifs dont les composants résistifs de puissance sont un exemple particulier, ainsi que sur tous les autres équipements dégageant de la chaleur et devant être refroidis en service.

A cet effet, l'invention propose un boîtier de composant(s) thermo-émissif(s), comprenant au moins une surface externe active de transfert thermique, qui est sensiblement plane et destinée à être mise en relation d'échange thermique avec au moins une surface externe sensiblement plane en regard sur un refroidisseur, extérieur au boîtier, et destiné à drainer la chaleur émise par ledit boîtier, lorsque ce dernier est en service et appliqué sous pression contre ladite surface externe du refroidisseur, et qui se caractérise en ce qu'il comprend au moins une capsule hermétique d'amélioration de la transmission thermique entre le boîtier et le refroidisseur, ladite capsule étant, d'une part, remplie d'au moins un matériau fluide bon conducteur de la chaleur qui enduit ladite surface externe active, et, d'autre part, délimitée par ladite surface externe active et au moins une barrière physique déformable, étanche au matériau fluide, et qui retient le matériau fluide contre ledit boîtier à l'aide de moyens de fixation reliant hermétiquement la périphérie de la barrière physique à la périphérie de ladite surface externe active du boîtier. Le matériau fluide, dont les caractéristiques peuvent être optimisées en vue de garantir les performances finales du boîtier installé, est ainsi protégé par la barrière physique, vis-à-vis des souillures comme vis-à-vis des pertes ou transferts accidentels de matériau fluide sur des corps non destinés à entrer en contact avec lui. La barrière physique garantit ainsi l'intégrité de la couche du matériau fluide, quelles que soient les conditions normales de manipulation. En service, lorsque le boîtier est monté sous pression sur le refroidisseur extérieur, la barrière physique et le matériau fluide de la capsule se déforment, de sorte à assurer un bon contact physique respectivement avec la surface externe active du boîtier et avec la surface externe d'appui du refroidisseur extérieur. De préférence, l'épaisseur de matériau fluide déposée sur la surface externe active du boîtier et la forme de la barrière physique et ses dimensions sont telles que le matériau fluide remplit complètement la capsule, de sorte que la quantité exacte de matériau fluide emprisonné dans la capsule joue le rôle de répartiteur-égalisateur de pression et contraint la barrière physique à épouser intimement toutes les imperfections, d'ordre de grandeur toléré, de la surface en regard sur le refroidisseur, grâce à la déformation et à la malléabilité du matériau de la barrière physique.

Le procédé selon l'invention, pour l'amélioration de la transmission thermique entre au moins un boîtier de composant(s) thermo-émissif(s) et au moins un refroidisseur extérieur au boîtier, et destiné à drainer la chaleur dissipée par ledit boîtier, lequel est du type comportant au moins une surface externe active de transfert thermique, sensiblement plane, destinée à être mise en relation d'échange thermique avec au moins une surface externe sensiblement plane, en regard sur ledit refroidisseur, se caractérise en ce qu'il comprend les étapes consistant à :
- enduire ladite surface externe active du boîtier avec au moins un matériau fluide, capable de fluer sous de faibles pressions, et de bonne conductibilité thermique,
- fixer hermétiquement la périphérie d'au moins une barrière physique déformable, mince et étanche au matériau fluide, sur la périphérie de ladite surface externe active dudit boîtier, de sorte à délimiter avec ladite surface externe active et ladite barrière physique au moins une capsule hermétique entre ledit boîtier et ledit refroidisseur, et
- à appliquer sous pression ledit boîtier par ladite capsule hermétique contre ledit refroidisseur.

Afin d'améliorer la malléabilité et déformabilité de la barrière physique, l'épaisseur de cette dernière est limitée à une valeur, de préférence aussi faible que possible, lui assurant une résistance mécanique suffisante pour supporter les manipulations normales du boîtier et les pressions de montage du boîtier contre le refroidisseur.

Dans des modes de réalisation préférés, on a recours, en outre, à l'une et/ou à l'autre des dispositions suivantes :
- la barrière physique comprend au moins une feuille souple d'un matériau bon conducteur de la chaleur, tel qu'un métal ou alliage métallique,
- la barrière physique comprend au moins une couche souple d'un matériau synthétique, tel que du polyimide, polypropylène ou polyéthylène, dont l'épaisseur est suffisamment faible pour présenter une résistance thermique négligeable,
- la barrière physique est stratifiée, par exemple colaminée, et comprend au moins un opercule métallique et au moins une couche d'un matériau synthétique,
- les moyens de fixation de la barrière physique sur le boîtier comprennent au moins une soudure, telle qu'une thermosoudure, soudure aux ultrasons ou à haute fréquence, et/ou au moins un collage, à chaud ou à froid, et/ ou au moins un moyen mécanique, tel qu'un sertissage, un agrafage ou une imbrication de formes,
- la quantité exacte de matériau fluide utilisée est déterminée pour combler au moins l'espace délimité entre la surface externe active du boîtier et la barrière physique,
- la viscosité du matériau fluide est choisie pour que ledit matériau flue sous la charge appliquée au montage du boîtier sur le refroidisseur jusqu'au contact positif en au moins une zone de la barrière physique simultanément avec la surface externe active du boîtier et avec la surface externe en regard sur le refroidisseur,
- le matériau fluide est constitué d'au moins un matériau, éventuellement métallique ou composite, capable de fluer sous des pressions faibles, tel qu'un fluide liquide, en gel ou pâteux, ayant une viscosité assurant de préférence une adhérence à la surface externe active du boîtier, ce qui permet le dépôt du matériau fluide sur le boîtier en épaisseur prédéterminée et reproductible en milieu industriel,
- le matériau fluide peut contenir au moins une charge métallique, minérale ou organique, telle que de l'oxyde d'aluminium et/ou de beryllium et/ou du nitrure d'aluminium et/ou de bore,
- au moins un volume réservoir peut être aménagé dans la capsule à la périphérie de cette dernière, pour recevoir du matériau fluide en excès chassé du volume délimité entre la surface externe active du boîtier et la barrière physique, à la mise en compression de la capsule entre le boîtier et le refroidisseur, ce volume réservoir étant, par exemple, délimité par au moins une zone flexible de la barrière physique qui est adjacente à sa périphérie fixée au boîtier,
- la barrière physique peut être rapportée après dépôt sur la surface externe active d'une épaisseur du matériau fluide qui est déterminée en fonction de la forme et des moyens de fixation de la barrière physique sur le boîtier, de sorte que le matériau fluide remplisse totalement le volume interne de la capsule, ou, au contraire,
- la barrière physique peut être créée par dépôt de matière par dessus le matériau fluide et sur le boîtier, à la périphérie de la surface externe active, la matière de la barrière physique formant une couche solide adhérant au boîtier sans adhérer au matériau fluide.

D'autres avantages et caractéristiques de l'invention ressortiront de la description donnée ci-dessous, à titre non limitatif, d'exemples de réalisation décrits en référence aux dessins annexés sur lesquels :
- la figure 1 représente schématiquement, en partie en coupe et en partie en élévation latérale, un boîtier de composant(s) thermo-émissif(s) équipé d'une capsule hermétique à fluide retenu par une barrière physique, et par l'intermédiaire de laquelle il est destiné à reposer sur un refroidisseur extérieur,
- la figure 2 est une vue analogue à la figure 1 d'un second exemple de boîtier de composant(s) thermo-émissif(s), qui se distingue du premier exemple de la figure 1 par les moyens de fixation de la barrière physique, et
- la figure 3 est une vue partielle analogue aux figures 1 et 2 d'un troisième exemple de boîtier, avec un volume réservoir dans la capsule pour loger du fluide en excès.

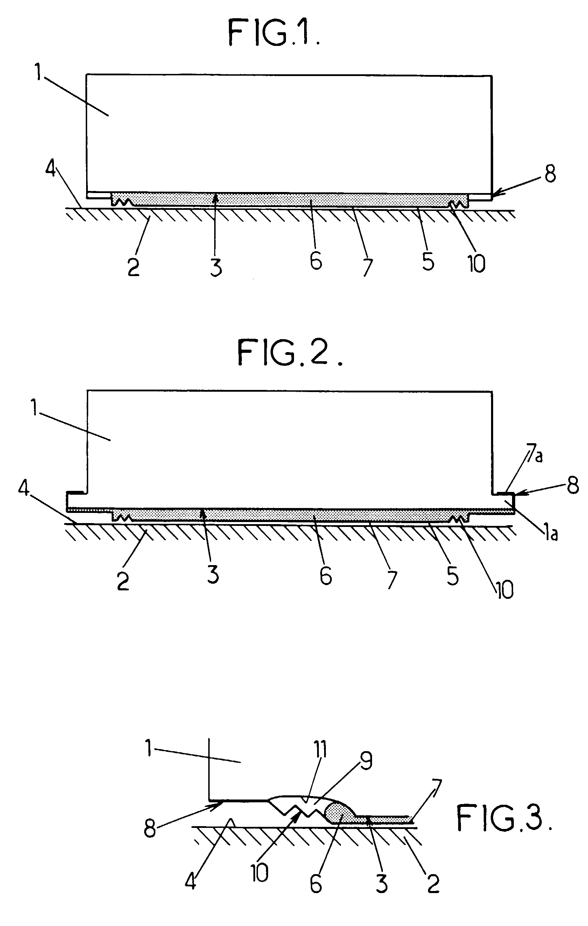

Sur la figure 1, on a représenté un boîtier 1 d'un composant résistif de puissance, qui, en fonctionnement, génère des calories devant être évacuées, pour que sa température de fonctionnement soit maintenue en service dans une plage acceptable, par un refroidisseur 2 présent dans le milieu extérieur, appelé également drain thermique ou dissipateur thermique, et sur lequel le boîtier 1, considéré comme une source de calories émettant un flux thermique, doit être implanté sous une pression déterminée.

L'embase du boîtier 1 présente une surface externe active 3 de transfert thermique, sensiblement plane, qui doit être mise en relation d'échange thermique avec la surface externe d'appui 4, sensiblement plane en regard, sur le drain thermique 2 extérieur au boîtier 1, pour lui transférer le flux de calories en excès émis par le boîtier 1.

Pour améliorer les échanges thermiques entre le boîtier 1 et le drain thermique extérieur 2, l'embase du boîtier 1 est équipée d'une capsule hermétique 5, par laquelle le boîtier 1 est appliqué sous pression contre le drain 2, et qui comprend essentiellement un matériau fluide 6 appliqué avec une épaisseur déterminée contre la surface active 3 du boîtier 1 et retenu par une barrière physique 7, solide mais déformable, dont la périphérie est fixée de manière étanche au matériau fluide 6 contre la périphérie de la surface active 3 par des moyens de fixation 8. Ainsi, ces moyens de fixation 8 ne gênent pas la déformation de la barrière 7 à la mise en appui sous pression du boîtier 1 sur le refroidisseur extérieur 2.

Le matériau fluide 6 est choisi pour présenter des caractéristiques optimisées en vue de garantir les performances finales du boîtier 1 installé sur le refroidisseur 2, et en particulier le matériau fluide 6 présente une bonne conductivité thermique. Ce matériau fluide 6 remplit le volume interne de la capsule 5, de sorte à disposer entre la surface externe active 3 et la face interne de la barrière 7, de la quantité de matériau fluide 6 nécessaire à l'obtention de la meilleure transmission thermique de la surface externe active 3 vers la surface externe d'appui 4 du refroidisseur 2.

Cette bonne transmission thermique est obtenue par le choix des constituants de la capsule 5, dont la barrière 7, étanche au matériau fluide 6 mais déformable, et dont le matériau fluide 6, malléable et bon conducteur de la chaleur, coopèrent de sorte que la barrière 7 et le matériau fluide 6 de la capsule épousent parfaitement les imperfections des surfaces externes 3 et 4 en regard, lors de l'installation du boîtier 1, dans des conditions de pression définies, non contraignantes par rapport aux règles conventionnelles de montage de tels boîtiers.

Le matériau fluide 6, qui constitue toujours une couche de transmission thermique, peut, éventuellement et en plus, constituer un écran électrique pour le boîtier 1, et être constitué d'une seule couche ou de plusieurs couches superposées de fluides, qui peuvent être des liquides, des gels ou des pâtes, ayant de préférence une viscosité suffisante pour assurer une bonne adhérence des fluides sur la surface externe active 3.

D'une manière générale, le matériau fluide 6 peut être constitué par le mélange, la juxtaposition ou la superposition de tels fluides, pouvant être métalliques ou composites, ou encore des huiles, ces fluides pouvant être chargés de charges métalliques, minérales ou organiques, par exemple de l'oxyde d'aluminium, du nitrure d'aluminium, du nitrure de bore ou encore de l'oxyde de beryllium, sans que cette liste soit limitative. La mouillabilité du ou des fluides choisis pour constituer le matériau fluide 6 doit être appropriée pour assurer la pénétration capillaire de toutes les imperfections de la surface active 3 enduite de ce matériau fluide 6. La malléabilité initiale est également un facteur déterminant dans le choix du ou des fluides entrant dans la composition du matériau fluide 6. On choisi des fluides capables de fluer sous des pressions faibles, de l'ordre de quelques dixièmes de MPa.

Le ou les fluides entrant dans la composition du matériau fluide 6, et ainsi interposé(s) entre la surface externe active 3 du boîtier 1, émetteur de flux thermique, et la barrière 7 en contact avec la surface externe d'appui 4 du drain extérieur 2, chargé d'évacuer les calories, présente(nt) de préférence de bonnes aptitudes au dépôt sur la surface active 3, par les techniques connues de sérigraphie, d'offset, de pulvérisation ou tout autre procédé connu de report et transfert de matière, à même de garantir la maîtrise de l'épaisseur prédéterminée du dépôt du matériau fluide 6 sur la surface 3 et sa reproductivité en milieu industriel.

L'épaisseur déposée du matériau fluide 6 engendre un volume au moins égal au volume intégral rendu probable par la tolérance maximum du défaut de planéité de la surface externe active 3 du boîtier 1 et de la surface 4 du drain thermique extérieur 2, en vue du comblement total, avec la barrière 7, de l'espace délimité entre la surface active 3 et la surface externe d'appui 4.

La barrière physique 7, qui recouvre le ou les fluides tels que décrits ci-dessus, remplit plusieurs fonctions, dont celle de retenir ce ou ces fluides et de les protéger des souillures, en évitant les pertes, notamment par évaporation, ainsi que les transferts accidentels de fluide sur des corps non destinés à entrer en contact avec le ou les fluides. D'une manière générale, cette barrière 7 garantit l'intégrité de la couche du matériau fluide 6 déposé contre la surface active 3, et donc ses performances nominales, quelles que soient les conditions normales de manipulation du boîtier 1 équipé de la capsule 5.

La réalisation de la barrière physique 7 peut faire appel à divers matériaux, pour obtenir une barrière 7 déformable, et de ce fait d'une épaisseur faible mais suffisante pour procurer à la barrière 7 une résistance mécanique suffisante pour les manipulations normales du boîtier 1 et son implantation sous pression contre le refroidisseur extérieur 2.

La barrière 7 peut être réalisée en une ou plusieurs couches de matériau souple, les matériaux bons conducteurs de la chaleur, tels que les métaux et alliages, étant préférés, mais les matériaux synthétiques, tels que le polyimide, le polyéthylène ou le polypropylène sont également utilisables, car l'épaisseur de la barrière 7 ou celle de ses couches constitutives en matériau synthétique est suffisamment faible pour ne présenter qu'une résistance thermique négligeable. La barrière 7 peut ainsi être réalisée à l'aide d'une ou plusieurs feuilles souples d'un métal ou alliage métallique bon conducteur de la chaleur, ou d'une ou plusieurs couches souples d'un matériau synthétique, ou encore avec une structure stratifiée comportant au moins une couche, feuille ou opercule métallique associé à au moins une couche synthétique, dans une structure par exemple colaminée.

Dans tous les cas, la compatibilité physico-chimique du ou des matériaux constitutifs de la barrière 7 avec le matériau constitutif de la surface externe d'appui 4 du drain extérieur 2 est respectée. Le choix du ou des matériaux de la barrière 7 est également guidé par le respect des exigences du cahier des charges électriques relatif à l'utilisation du boîtier 1, par exemple l'isolement galvanique, la maîtrise des phénomènes de décharge partielle, etc...

Les moyens 8 de fixation de la périphérie de la barrière 7 contre la périphérie de la surface active 3 doivent garantir l'étanchéité de la capsule 5 ainsi qu'une résistance aux manipulations et utilisations normales du boîtier 1. Cette fixation hermétique peut être assurée, par exemple, par soudure, notamment par thermosoudure, soudure aux ultrasons ou soudure à haute fréquence, selon les matériaux constitutifs de la barrière 7 et de la périphérie de la surface active 3 du boîtier 1, ou encore par collage, notamment par thermocollage ou collage à froid, comme cela est schématisé sur la figure 1, ou encore par sertissage ou imbrication de formes, comme schématisé sur la figure 2, sur laquelle le bord périphérique de la barrière 7 est représenté serti ou replié en 7a par dessus un rebord périphérique en saillie latérale la du boîtier 1. Ces moyens de fixation ne sont pas limitatifs, et peuvent également comprendre un agrafage, et ils peuvent être utilisés en diverses combinaisons.

L'herméticité ainsi assurée à la capsule 5 par le choix de moyens 8 de fixation appropriés aux manipulations et conditions d'utilisation du boîtier 1 ainsi qu'aux matériaux constitutifs des éléments à fixer les uns aux autres, permet d'éviter les risques de dégradation, par exemple pendant le stockage, par évaporation, diffusion, écoulement, etc... du ou des fluides 6, et la capsule 5 étanche peut également supporter d'éventuelles opérations de nettoyage et/ou dépoussiérage, sans incidence sur les caractéristiques du ou des fluides 6.

Au cours du procédé de réalisation du boîtier 1 à transmission thermique améliorée par la présence d'une capsule 5, et après l'étape de dépôt du ou des fluides 6 sur la surface active 3 du boîtier 1, l'étape de mise en place de la barrière 7, ainsi que sa forme et le choix des moyens 8 de sa fixation étanche contre le boîtier 1 garantissent le remplissage de la capsule 5 par l'exacte quantité de matériau fluide 6 nécessaire. Pour cela, et au moins sur la face interne de la barrière 7, mais de préférence également sur sa face externe, toutes les cavités parasites, bulles, poches ou films d'air sont éliminés par une ou plusieurs étapes préalables de préparation, par exemple par calandrage, laminage, passage sous vide et/ou sous pression.

L'épaisseur et l'homogénéité de la capsule 5, et donc de ses éléments constitutifs, sont les facteurs principaux de l'obtention des performances recherchées, et doivent donc être soigneusement contrôlées.

Lors de l'installation du boîtier 1 sur le refroidisseur extérieur 2, par des techniques d'assemblage mécanique exerçant les pressions de montage prescrites, la quantité exacte de matériau fluide 6 emprisonnée dans la capsule 5 joue le rôle d'élément égalisateur et répartiteur de pression, en forçant la barrière 7 à épouser intimement toutes les imperfections, d'ordre de grandeur toléré, de la surface active 3 et de la surface externe d'appui 4 en regard l'une de l'autre respectivement sur le boîtier 1 et le refroidisseur 2, grâce à la malléabilité et déformabilité de la barrière 7. Comme déjà dit, la quantité exacte de matériau fluide 6 est déterminée pour remplir au moins l'espace compris entre la barrière 7 et la surface active 3 du boîtier 1. De préférence, la viscosité du matériau fluide 6 est choisie pour que ce matériau flue sous la charge appliquée jusqu'à ce qu'il se produise au moins un contact positif entre la surface active 3 et la surface d'appui 4, par l'intermédiaire de la barrière 7, cette situation étant établie lorsque trois points au moins sont en contact. En d'autres termes, dans une zone de la barrière 7, il y a alors simultanément contact de cette barrière 7 avec la surface d'appui 4 du refroidisseur 2 et avec la surface active 3 du boîtier 1. Dans cette condition, l'épaisseur maximum du matériau fluide 6 en un endroit quelconque dans la capsule 5 ne dépasse la somme des imperfections tolérées de la géométrie des surfaces 3 et 4 en regard. La quantité de matériau fluide 6 qui est alors chassée du volume situé entre la barrière 7 et la partie de la surface active 3 en regard se répartit à la périphérie de la capsule 5, à l'intérieur de cette dernière ainsi compressée, dans un espace aménagé sans débordement du fait des formes choisies et de l'herméticité de la capsule 5, grâce à une zone flexible, repérée en 10, de la barrière 7 qui est adjacente à sa zone périphérique fixée par les moyens 8 au boîtier 1.

L'exemple de la figure 3 ne se distingue de ceux des figures 1 et 2 que par la présence d'au moins un volume réservoir 9, délimité à l'intérieur et à la périphérie de la capsule 5 entre la zone flexible 10 de la barrière 7 et un évidement 11 ménagé dans la surface active 3, en regard de cette zone flexible 10, pour recevoir la quantité en excès de matériau fluide 6 qui est chassée vers ce ou ces volumes réservoir 9, lors de la compression de la capsule 5, au montage du boîtier 1 sur le refroidisseur 2.

L'ensemble des caractéristiques décrites ci-dessus procure à la liaison entre le boîtier 1 et le refroidisseur 2 une excellente conductibilité thermique, se traduisant par une impédance thermique très basse. Cette impédance thermique est ainsi maîtrisée sans utilisation de produit auxiliaire, lors de l'installation du boîtier 1 équipé de sa capsule 5, dans des conditions de reproductibilité garantie, et d'une façon simple pour les utilisateurs.

Lors de la réalisation de la capsule 5 sur le boîtier 1, et après le dépôt du matériau fluide 6, dans les conditions précisées ci-dessus, la barrière 7 peut être rapportée par exemple par dépôt d'un film ou d'une feuille de structure appropriée par dessus le matériau fluide 6 et sur la périphérie de la surface active 3, à laquelle cette barrière est ensuite fixée de manière étanche, ou, en alternative, la barrière physique 7 est créée par dessus la couche de matériau fluide 6 déposée et sur la périphérie de la surface 3, par un dépôt de matière qui forme une couche solide adhérant au boîtier 1 sans adhérer au matériau fluide 6, et étant par exemple en polymère chargé de noir de carbone, pour réaliser une barrière 7 semi-isolante, ou encore chargée d'un anti-adhésif tel que du polytétrafluoroéthylène (PTFE), ce dépôt de matière pouvant se faire au pistolet, par sérigraphie ou par d'autres procédés de dépôt.

On comprend que le procédé et le boîtier de composant(s) thermo-émissif(s) perfectionné de l'invention peuvent être mis en oeuvre sur tous les composants électriques, électroniques, actifs ou passifs, dont les résistances de puissance ne sont qu'un exemple particulier, ainsi que sur tous les autres équipements dégageant de la chaleur.

## Revendications

1. Boîtier de composant(s) thermo-émissif(s) (1), comprenant au moins une surface externe active (3) de transfert thermique, qui est sensiblement plane et destinée à être mise en relation d'échange thermique avec au moins une surface externe (4) sensiblement plane en regard sur un refroidisseur (2), extérieur au boîtier (1), et destiné à drainer la chaleur émise par ledit boîtier (1), lorsque ce dernier est en service et appliqué sous pression contre ladite surface externe (4) du refroidisseur (2), ledit boîtier comprenant au moins une capsule (5) hermétique d'amélioration de la transmission thermique entre le boîtier (1) et le refroidisseur (2), ladite capsule (5) étant remplie d'au moins un matériau fluide (6) bon conducteur de la chaleur qui enduit ladite surface externe active (3), ladite capsule (5) étant délimitée par ladite surface externe active (3), et par au moins une barrière physique (7) déformable, étanche au matériau fluide (6), et qui retient le matériau fluide (6) contre ledit boîtier (1), des moyens de fixation (8) reliant hermétiquement la périphérie de la barrière physique (7) à la périphérie de ladite surface externe active (3) du boîtier (1).

2. Boîtier selon la revendication 1, caractérisé en ce que l'épaisseur de la barrière physique (7) est limitée à une valeur lui assurant une résistance mécanique suffisante pour supporter les manipulations du boîtier (1) et les pressions de montage du boîtier (1) contre le refroidisseur (2).

3. Boîtier selon l'une des revendications 1 et 2, caractérisé en ce que ladite barrière physique (7) comprend au moins une feuille souple d'un matériau bon conducteur de la chaleur, tel qu'un métal ou alliage métallique.

4. Boîtier selon l'une quelconque des revendications 1 à 3, caractérisé en ce que ladite barrière physique (7) comprend au moins une couche souple d'un matériau synthétique, tel que du polyimide, polypropylène ou polyéthylène, dont l'épaisseur est suffisamment faible pour présenter une résistance thermique négligeable.

5. Boîtier selon l'une quelconque des revendications 1 à 4, caractérisé en ce que ladite barrière physique (7) est stratifiée, par exemple colaminée, et comprend au moins un opercule métallique et au moins une couche d'un matériau synthétique.

6. Boîtier selon l'une quelconque des revendications 1 à 5, caractérisé en ce que les moyens (8) de fixation de la barrière physique (7) sur le boîtier (1) comprennent au moins une soudure, telle qu'une thermosoudure, soudure aux ultrasons ou à haute fréquence, et/ou au moins un collage, à chaud ou à froid, et/ou au moins un moyen mécanique, tel qu'un sertissage, un agrafage ou une imbrication de formes.

7. Boîtier selon l'une quelconque des revendications 1 à 6, caractérisé en ce que la quantité exacte de matériau fluide (6) utilisée est déterminée pour combler au moins l'espace délimité entre la surface externe active (3) du boîtier (1) et la barrière physique (7).

8. Boîtier selon l'une quelconque des revendications 1 à 7, caractérisé en ce que la viscosité du matériau fluide (6) est choisie pour que ledit matériau flue sous la charge appliquée au montage du boîtier (1) sur le refroidisseur (2) jusqu'au contact positif en au moins une zone de la barrière physique (7) simultanément avec la surface externe active (3) du boîtier (1) et avec la surface externe (4) en regard sur le refroidisseur (2).

9. Boîtier selon l'une quelconque des revendications 1 à 8, caractérisé en ce que ledit matériau fluide (6) est constitué d'au moins un matériau, éventuellement métallique ou composite, capable de fluer sous des pressions faibles, tel qu'un fluide liquide, en gel ou pâteux, ayant une viscosité assurant de préférence une adhérence à la surface externe active (3) du boîtier (1).

10. Boîtier selon la revendication 9, caractérisé en ce que le matériau fluide (6) contient au moins une charge métallique, minérale ou organique, telle que de l'oxyde d'aluminium et/ou de beryllium et/ou du nitrure d'aluminium et/ou de bore.

11. Boîtier selon l'une quelconque des revendications 1 à 10, caractérisé en ce qu'au moins un volume réservoir (9) est aménagé dans la capsule (5), à la périphérie de cette dernière, pour recevoir du matériau fluide (6) en excès chassé du volume délimité entre la surface externe active (3) du boîtier (1) et la barrière physique (7), à la mise en compression de la capsule (5) entre le boîtier (1) et le refroidisseur (2) extérieur.

12. Boîtier selon la revendication 11, caractérisé en ce que ledit volume réservoir (9) est délimité par au moins une zone flexible (10) de la barrière physique (7) qui est adjacente à sa périphérie fixée au boîtier (1).

13. Procédé d'amélioration de la transmission thermique entre au moins un boîtier de composant(s) thermo-émissif(s) (1) et au moins un refroidisseur (2), extérieur au boîtier (1), et destiné à drainer la chaleur dissipée par ledit boîtier (1), lequel est du type comportant au moins une surface externe active (3) de transfert thermique, sensiblement plane, destinée à être mise en relation d'échange thermique avec au moins une surface (4) externe, sensiblement plane, en regard sur ledit refroidisseur (2), ledit procédé comprenant les étapes consistant à :
- enduire ladite surface externe active (3) du boîtier (1) avec au moins un matériau fluide (6), capable de fluer sous de faibles pressions, et de bonne conductibilité thermique,
- fixer hermétiquement (8) la périphérie d'au moins une barrière physique déformable (7), mince et étanche au matériau fluide (6), sur la périphérie de ladite surface externe active (3) dudit boîtier (1), de sorte à délimiter avec ladite surface externe active (3) et ladite barrière physique (7) au moins une capsule hermétique (5) entre ledit boîtier (1) et ledit refroidisseur (2), et
- à appliquer sous pression ledit boîtier (1) par ladite capsule hermétique (5) contre ledit refroidisseur (2).

14. Procédé selon la revendication 13, caractérisé en ce que ladite barrière physique (7) est rapportée, après dépôt sur ladite surface externe active (3) d'une épaisseur du matériau fluide (6), qui est déterminée en fonction de la forme et des moyens de fixation (8) de la barrière physique (7) sur le boîtier (1), de sorte que le matériau fluide (6) remplisse totalement le volume interne de la capsule (5).

15. Procédé selon la revendication 13, caractérisé en ce que ladite barrière physique (7) est créée par dépôt de matière par dessus le matériau fluide (6) et sur le boîtier (1), à la périphérie de la surface externe active (3), la matière de la barrière physique (7) formant une couche solide adhérant au boîtier (1) sans adhérer au matériau fluide (6).

## Patentansprüche

1. Gehäuse (1) für (einen) Wärme emittierenden Bestandteil(en) mit wenigstens einer einen Wärmeaustausch bewirkenden aktiven Außenfläche (3), die im wesentlichen eben ausgebildet ist, wobei sie in einer Wärmeaustauschbeziehung zu wenigstens einer im wesentlichen eben ausgebildeten Außenfläche (4) steht, die entgegenliegend auf einer Kühleinrichtung (2) vorgesehen ist, welche sich außerhalb des Gehäuses (1) befindet und weiterhin dazu bestimmt ist, die von dem genannten Gehäuse (1) abgegebene Wärme abzuleiten, wenn dieses in Betrieb ist und unter Druck an der genannten Außenfläche (4) der Kühleinrichtung (2) festgehalten wird,
wobei das genannte Gehäuse (1) wenigstens eine hermetische Kapsel (5) für die Verbesserung des Wärmeaustausches zwischen dem Gehäuse (1) und der Kühleinrichtung (2) aufweist, wobei die genannte Kapsel (5) mit wenigstens einem fließfähigen Material (6) mit guten Wärmeleiteigenschaften gefüllt ist, das die genannte aktive Außenfläche (3) überzieht, wobei die genannte Kapsel (5) von der genannten aktiven Außenfläche (3) und von wenigstens einer deformierbaren und gegenüber dem fließfähigen Material (6) dichten physischen Barriere (7) begrenzt wird, die das fließfähige Material (6) gegenüber dem Gehäuse (1) zurückhält, und wobei Befestigungsmittel (8) vorgesehen sind, die den Umfang der physischen Barriere (7) hermetisch mit dem Umfang der genannten aktiven Außenfläche (3) des Gehäuses (1) verbinden.

2. Gehäuse nach Anspruch 1, dadurch gekennzeichnet, dass die Stärke der physischen Barriere (7) auf einen Wert beschränkt ist, der einen ausreichenden mechanischen Widerstand sicherstellt, um Arbeiten an dem Gehäuse (1) und den bei der Montage des Gehäuses (1) an der Kühleinrichtung (2) auftretenden Druck auszuhalten.

3. Gehäuse nach einem der Ansprüche 1 und 2, dadurch gekennzeichnet, dass die genannte physische Barriere (7) wenigstens eine nachgiebige Folie aus einem Material mit guten Wärmeleiteigenschaften, wie beispielsweise aus Metall oder aus einer Metall-Legierung, aufweist.

4. Gehäuse nach irgendeinem der Ansprüche 1 bis 3, dadurch gekennzeichnet, dass die genannte physische Barriere (7) wenigstens eine nachgiebige Schicht aus einem synthetischen Material, wie beispielsweise Polyimid, Polypropylen oder Polyäthylen, aufweist, deren Stärke dünn genug ist, um einen ignorierbaren thermischen Widerstand aufzuweisen.

5. Gehäuse nach irgendeinem der Ansprüche 1 bis 4, dadurch gekennzeichnet, dass die genannte physische Barriere (7) aus Schichten hergestellt, beispielsweise laminiert, ist und wenigstens einen metallischen Deckel und eine Schicht aus einem synthetischen Material aufweist.

6. Gehäuse nach irgendeinem der Ansprüche 1 bis 5, dadurch gekennzeichnet, dass die Mittel (8) zur Befestigung der physischen Barriere (7) am Gehäuse (1) aus wenigstens einer Schweißnaht, beispielsweise erzeugt durch Thermoschweißen, Ultraschall- oder Hochfrequenzschweißen, und/oder einem Heiß- oder Kaltkleber und/oder wenigstens einem mechanischen Mittel, wie einer Quetschverbindung, einer Klammerverbindung oder einer Verschachtelung der Formen, bestehen.

7. Gehäuse nach irgendeinem der Ansprüche 1 bis 6, dadurch gekennzeichnet, dass die genaue Menge des verwendeten fließfähigen Materials (6) so bestimmt wird, dass wenigstens der von der aktiven Außenfläche (3)des Gehäuses (1) und der physischen Barriere (7) umschlossene Raum ausgefüllt ist.

8. Gehäuse nach irgendeinem der Ansprüche 1 bis 7, dadurch gekennzeichnet, dass die Viskosität des fließfähigen Materials (6) so gewählt ist, dass das genannte Material unter den bei der Montage des Gehäuses (1) an der Kuhleinrichtung (2) auftretenden Belastungen bis zur Herstellung eines positiven Kontakts auf wenigstens einem Bereich der physischen Barriere (7) gleichzeitig mit der aktiven Außenfläche (3) des Gehäuses (1) sowie der Außenfläche (4) an der Kühlvorrichtung (2) fließt

9. Gehäuse nach irgendeinem der Ansprüche 1 bis 8, dadurch gekennzeichnet, dass das genannte fließfähige Material (6) aus wenigstens einem Stoff, eventuell einem metallischen oder zusammengesetzten Stoff, besteht, der in der Lage ist, unter einem schwachen Druck zu fließen, wie beispielsweise ein flüssiges, gelförmiges oder pastöses Medium, und der eine Viskosität aufweist, der ein Haftvermögen an der aktiven Außenfläche (3) des Gehäuses (1) sicherstellt.

10. Gehäuse nach Anspruch 9, dadurch gekennzeichnet, dass das fließfähige Material (6) wenigstens einen metallischen, mineralischen oder organischen Anteil aufweist, wie beispielsweise Aluminium- und/oder Berylliumoxid und/oder Aluminium- und/oder Bomitrid.

11. Gehäuse nach irgendeinem der Ansprüche 1 bis 10, dadurch gekennzeichnet, dass wenigstens ein Volumenreservoir (9) in der Kapsel (5) am Umfang der letzteren vorgesehen ist, um das fließfähige Material (6) aufzunehmen, das als Überschuss aus dem von der aktiven Außenfläche (3) des Gehäuses (1) und der physischen Barriere (7) begrenzten Raum herausfließt, wenn die Kapsel (5) zwischen dem Gehäuse (1) und der äußeren Kühleinrichtung (2) zusammengedrückt wird.

12. Gehäuse nach Anspruch 11, dadurch gekennzeichnet, dass das genannte Volumenreservoir (9) von wenigstens einem flexiblen Bereich (10) der physischen Barriere (7) begrenzt wird, der an den Umfangsbereich anschließt, der am Gehäuse (1) befestigt ist.

13. Verfahren zur Verbesserung des Wärmeaustausches zwischen wenigstens einem Gehäuse (1) für (einen) Wärme emittierenden Bestandteil(en) und wenigstens einer Kühlvorrichtung (2), die sich außerhalb des Gehäuses (1) befindet und zum Ableiten der von dem genannten Gehäuse (1) abgegebenen Wärme bestimmt ist, wobei dieses wenigstens eine im wesentlichen ebene aktive Außenfläche (3) für den Wärmeaustausch aufweist, die in einer Wärmeaustauschbeziehung zu wenigstens einer im wesentlichen eben ausgebildeten und auf der genannten Kühleinrichtung (2) vorgesehenen Außenfläche (4) steht, wobei das genannte Verfahren die folgenden Schritte umfasst:
- Überziehen der genannten aktiven Außenfläche (3) des Gehäuses (1) mit wenigstens einem fließfähigen Material (6), das in der Lage ist, unter schwachem Druck zu fließen und gute Wärmeleiteigenschaften hat,
- hermetische Befestigung (8) des Umfangs wenigstens einer deformierbaren, dünnen und gegenüber dem fließfähigen Material (6) dichten physischen Barriere (7) auf dem Umfang der genannten aktiven Außenfläche (3) des Gehäuses (1), so dass durch diese aktive Außenfläche (3) und diese physische Barriere (7) wenigstens eine hermetische Kapsel (5) zwischen dem genannten Gehäuse (1) und der genannten Kühleinrichtung (2) begrenzt wird, und
- Anbringen des genannten Gehäuses (1) unter Druck an der genannten Kühleinrichtung (2) mittels der genannten hermetischen Kapsel (5).

14. Verfahren nach Anspruch 13, dadurch gekennzeichnet, dass die genannte physische Barriere (7) aufgebracht wird, nach Anordnung auf der gennanten aktiven Außenfläche (3) eine Schicht aus fließfähigem Material (6) die in Abhängigkeit von der Form und der Art der Befestigung (8) der physischen Barriere (7) auf dem Gehäuse (1) derart beschaffen ist, dass das fließfähige Material (6) das Innenvolumen der Kapsel (5) vollständig ausfüllt.

15. Verfahren nach Anspruch 13, dadurch gekennzeichnet, dass die genannte physische Barriere (7) durch Anordnung von Werkstoffen oberhalb des fließfähigen Materials (6) und auf dem Gehäuse (1) erzeugt wird, auf dem Umfang der aktiven AuBenfläche (3), wobei das Material der physischen Barriere (7) eine solide Schicht bildet, die an dem Gehäuse (1) haftet, während sie an dem fließfähigen Material (6) nicht haften bleibt.

## Claims

1. A box for (a) heat-emitting component(s) (1), having at least one active, external heat-transfer surface (3), which is substantially flat and designed to co-operate in a heat-transfer function with at least one substantially flat, external surface (4) facing it on a cooler (2), external to the box (1), and designed to dissipate the heat emitted by said box (1) when this latter is in service, and applied against said external surface (4) of the cooler (2) under pressure, said box having at least one hermetic capsule (5) for improving heat transmission between the box (1) and the cooler (2), said capsule (5) being filled with at least one fluid material (6), which is a good heat conductor, applied to said active external surface (3), said capsule (5) being delimited by said active external surface (3) and by at least one deformable physical barrier (7) impermeable to the fluid material (6) and which retains the fluid material (6) against said box (1), fixing means (8) hermetically joining the periphery of the physical barrier (7) to the periphery of said active external surface (3) of the box (1).

2. A box as claimed in claim 1, characterised in that the thickness of the physical barrier (7) is limited to a value that will impart to it sufficient mechanical strength to withstand the manipulations of the box (1) and the pressures under which the box (1) is mounted against the cooler (2).

3. A box as claimed in one of claims 1 and 2, characterised in that said physical barrier (7) has at least one flexible sheet of a good heat-conducting material such as a metal or a metal alloy.

4. A box as claimed in any one of claims 1 to 3, characterised in that said physical barrier (7) has at least one flexible layer of a synthetic material such as polyimide, polypropylene or polyethylene, the thickness of which is sufficiently small to exhibit a negligible resistance to heat.

5. A box as claimed in any one of claims 1 to 4, characterised in that said physical barrier (7) is stratified, for example co-laminated, and has at least one metal foil and at least one layer of a synthetic material.

6. A box as claimed in any one of claims 1 to 5, characterised in that the means (8) for joining the physical barrier (7) onto the box (1) comprise at least one weld, such as a heat-seal, an ultrasound or high frequency weld and/or at least one bond, which may a hot or cold bond, and/or at last one mechanical means such as a crimping, stapling or interleaved shapes.

7. A box as claimed in any one of claims 1 to 6, characterised in that the exact quantity of fluid material (6) to be used is determined so that at least the space delimited between the active external surface (3) of the box (1) and the physical barrier (7) is filled.

8. A box as claimed in any one of claims 1 to 7, characterised in that the viscosity of the fluid material (6) is chosen so that said material flows under the load applied when mounting the box (1) on the cooler (2) until a positive contact is formed in at least one zone of the physical barrier (7) with the active external surface (3) of the box (1) and with the external surface (4) on the cooler (2) facing it simultaneously.

9. A box as claimed in any one of claims 1 to 8, characterised in that said fluid material (6) is at least a material, optionally metal or composite, capable of flowing under low pressure such as a liquid, gel or pasty fluid, having a viscosity that will preferably ensure adhesion to the active external surface (3) of the box (1) .

10. A box as claimed in claim 9, characterised in that the fluid material (6) contains at least one metal, mineral or organic filler such as aluminium and/or beryllium oxide and or aluminium and/or boron nitride.

11. A box as claimed in any one of claims 1 to 10, characterised in that at least a reservoir volume (9) is arranged in the capsule (5), at the periphery thereof, to receive excess fluid material (6) driven out from the volume delimited between the active external surface (3) of the box (1) and the physical barrier (7) when the capsule (5) is compressed between the box (1) and the external cooler (2) .

12. A box as claimed in claim 11, characterised in that said reservoir volume (9) is delimited by at least one flexible zone (10) of the physical barrier (7) which is adjacent to the periphery thereof joined to the box (1).

13. A method of improving heat transmission between at least one box for (a) heat-emitting component(s) (1) and at least one cooler (2), external to the box (1), and designed to dissipate the heat given off by said box (1), which is of the type having at least one substantially flat, active external heat-transfer surface (3) designed to co-operate in a heat exchange function with at least one substantially flat, external surface (4) facing it on said cooler (2), said method comprising the following steps, consisting in:
- coating said active external surface (3) of the box (1) with at least one fluid material (6), capable of flowing at low pressures and having a good heat conductivity,
- hermetically joining (8) the periphery of at least one thin, deformable physical barrier (7), which is impermeable to the fluid material (6), onto the periphery of said active, external surface (3) of said box (1) so as to delimit with said active external surface (3) and said physical barrier (7) at least one hermetic capsule (5) between said box (1) and said cooler (2) and
- applying said box (1) by means of said hermetic capsule (5) against said cooler (2) under pressure.

14. A method as claimed in claim 13, characterised in that said physical barrier (7) is joined on after a thickness of fluid material (6) has been deposited on said active external surface (3), this being determined on the basis of the shape and fixing means (8) of the physical barrier (7) to the box (1) so that the fluid material (6) completely fills the interior volume of the capsule (5).

15. A method as claimed in claim 13, characterised in that said physical barrier (7) is created by depositing a substance above the fluid material (6) and on the box (1) at the periphery of the active external surface (3), the substance of the physical barrier (7) forming a solid layer adhering to the box (1) without adhering to the fluid material (6).
